# EUROPEAN PATENT APPLICATION

(11) **EP 1 414 172 A1**
(43) Date of publication of application: **28.04.2004**
(21) Application number: 02730808.9
(22) Date of filing: 30.05.2002
(51) Int. Cl.: H04J 3/00, H03G 3/20, H04Q 7/38

(54) **AUTOMATIC GAIN CONTROLLING DEVICE AND METHOD, AND RADIO COMMUNICATION DEVICE**

(30) Priority: 27.07.2001 JP 2001227739
(71) Applicant: MATSUSHITA ELECTRIC INDUSTRIAL CO., LTD., Kadoma-shi, Osaka 571-0050 (JP)
(72) Inventor: MUTO, Masaki, Yokohama-shi, Kanagawa 223-0062 (JP)
(74) Representative: Grünecker, Kinkeldey, Stockmair & Schwanhäusser Anwaltssozietät
(86) International application number: PCT/JP2002/005299
(87) International publication number: WO 2003/013036

(57) **Abstract**

In a cellular system which is based on the TDMA system performing multi-slot communications, a DSP and a controller detect the received signal strength in each of a plurality of time slots received by an RF input section and, in case the received signal strength is abnormal, assign a weight to the received signal strength which is lighter than that assigned to a normal value thus calculating a received signal average strength in each time slot. In case each of these received signal average strength is abnormal, the DSP and the controller assign a weight to the received signal strength which is lighter than that assigned to a normal value to calculate the average value of a plurality of received signal average strengths in a frame. A gain control signal which is based on the average multi-slot received strength is fed back to an automatic gain control circuit to perform automatic gain control for setting the received signal strength to a predetermined value. This makes it possible to receive signals in a plurality of time slots in a frame by way of a same gain setting in a stable fashion.

## Description

### <Technical Field>

The present invention relates to an automatic gain controller, an automatic gain control method and radio communications apparatus which perform gain control in receiving signals in a plurality of time slots in a frame in a cellular system which is based on the TDMA system such as a radio mobile telephone system of the GSM system.

### <Background of the Invention>

A cellular system which uses cell phones, etc. to perform mobile communications, for example, the GSM (Global System for Mobile Communications) system, comprises at least one MSC (Mobile Services Switching Center) which is connected to a telephone circuit network. The MSC is further connected to a plurality of lower BSCs (Base Station Controllers), each of which is connected to at least one lower BTS (Base Transceiver Station) and communications are performed between these nodes. In a cell as a communications area managed by each base transceiver station, radio communications are performed between an MS (Mobile Station) and the base transceiver station. While traveling, the MS can communicate with another MS or a telephone circuit network.

In radio communications of the TDMA system (TDMA communications) used for example in a cellular system which is based on the GSM system (a GSM system), a plurality of MSs communicate with a base transceiver station in a single frequency channel in accordance with the time-division multiplexing system. In this case, an MS tracks the signal timing of a base transceiver station to perform communications, number of frequencies and signal strength, etc. in order to provide synchronization of a receiver with a transmitter and maintains the communications state where signals are communicated.

A change in the signal strength in radio communications is caused by attenuation dependent on the distance between a transmitter and a receiver, shadow fading due to a physical obstacle interrupting a straight route, Rayleigh fading due to a receiver traveling in a large number of reflected signals, etc. Shadow fading has space correlation which is assumed as a phenomenon common to a large number of wavelengths. Rayleigh fading has no correlation between burst signals and varies with time depending on the communication state. Thus, an average value of signal strengths of burst signals is sometimes obtained to eliminate the effect of Rayleigh fading.

In TDMA communications in a related art GSM system, etc., only one time slot is assigned to a user (an MS) of a frame in a frequency channel used for communications. Thus, obtaining a mean value of burst signal strength in a time slot can eliminate the effect of Rayleigh fading. However, in the GPRS (General Packet radio Service) as a packet communications system recently employed by the GSM system, multi-slot communications aiming at faster communications speed is performed and burst signals are received in a plurality of time slots for a user of a frame. Thus, in order to eliminate the effect of Rayleigh fading, it is necessary to obtain an average value of burst signal strengths in a plurality of time slots in a frame.

In case burst signals in a plurality of time slots in a frame are received via a single gain setting in the above-mentioned multi-slot communications, when a specific time slot is substantially influenced by fading, channel interference or a timing lag, an average value of received signal strengths may be greatly changed by a change in signal strength in the time slot. In such a case, automatic gain control cannot be performed on a desired gain and an adverse effect of fading, etc. thereby increasing an error in automatic gain control.

### <Disclosure of the Invention>

This invention has been accomplished in view of the aforementioned problems and aims at providing an automatic gain controller, an automatic gain control method and radio communications apparatus which can receive signals in a plurality of time slots in a frame by way of a same gain setting in a stable fashion with reduced effect of fading, etc. in a cellular system which is based on the TDMA system performing multi-slot communications.

An automatic gain controller according to the invention controls the signal strength to a predetermined level in time-division-based multi-slot communications which perform communications in a plurality of time slots in a predetermined frame time, characterized in that the automatic gain controller comprises received signal strength detecting means for detecting a received signal strength in each of the plurality of time slots, received signal average strength calculating means for determining whether the detected received signal strength is abnormal and in case the signal strength value is abnormal, assigning a weight to the received signal strength which is lighter than that assigned to a normal value thus calculating a received signal average strength in each time slot, average multi-slot received strength calculating means for determining whether the calculated received signal average strength is abnormal, and in case the signal strength is abnormal, assigning a weight to the received signal strength which is lighter than that assigned to a normal value thus calculating an average value of a plurality of received signal average strengths in a frame, and gain control means for controlling the received signal strength to a predetermined level by using a gain control signal which is based on the calculated average multi-slot received strength.

Preferably, the automatic gain controller is characterized in that the received signal average strength calculating means comprises comparing means for making a comparison to determine whether the detected received signal strength exceeds a predetermined tolerance and weight setting means for assuming an abnormal value in case the tolerance is exceeded in the result of the comparison and setting a correction value used as a coefficient of the weight to 0 or a value approximate to 0.

Preferably, the automatic gain controller is characterized in that the average multi-slot received strength calculating means comprises comparing means for making a comparison to determine whether the calculated received signal average strength exceeds a predetermined tolerance and weight setting means for assuming an abnormal value in case the tolerance is exceeded in the result of the comparison and setting a correction value used as a coefficient of the weight to 0 or a value approximate to 0.

In the foregoing configuration, in case multi-slot communications are performed in a plurality of time slots in a predetermined frame time, received signal strength in each of the plurality of time slots is detected and received signal strength is obtained for example by cyclically sampling the time slots, whether the signal strength values are abnormal and in case they are abnormal, a weight is assigned to a received signal average strength in the time slot which is lighter than that assigned to a normal value in order to calculate an average value of a plurality-of received signal average strengths in a frame. Based on the calculated average multi-slot received strength, for example the average multi-slot received strength is used as a gain control signal for the subsequent frame to perform automatic gain control so that the receiving signal strength will be at a predetermined level. This reduces the effect of fading, etc. and makes it possible to receive burst signals in a plurality of time slots in a frame by way of a same gain setting in a stable fashion.

### <Brief Description of the Drawings>

Fig. 1 is a block diagram showing a configuration of a receiver for multi-slot communications equipped with an automatic gain controller according to one embodiment of the invention;
Fig. 2 is a block diagram schematically showing a network configuration of a TDMA-based cellular system;
Fig. 3 shows a frame configuration of eight time slots of GSM system as an exemplary TDMA-based frame configuration;
Fig. 4 schematically shows the timing and received signal strength of multi-slot reception of burst signals in four time slots in a frame; and
Fig. 5 is a flowchart showing the procedure for obtaining the gain value of an automatic gain control circuit for burst signal reception in multi-slot communications in a receiver for multi-slot communications according to this embodiment.

In the figures, a numeral 1 represents an antenna, 2 an RF input section, 3 an automatic gain control circuit, 4 a demodulator, 5 a decoder, 6 a sampling circuit, 7 a DSP, 8 a voice output section, 9 a controller, 10a an AGC signal input terminal, 10b a synchronization signal input terminal, 11 through 18 signal time slots in frame n-1, 21 through 28 signal time slots in frame n, and 31 through 38 signal time slots in frame n+1.

### <Best Mode for Carrying Out the Invention>

Embodiments of the invention will be described below referring to the drawings.

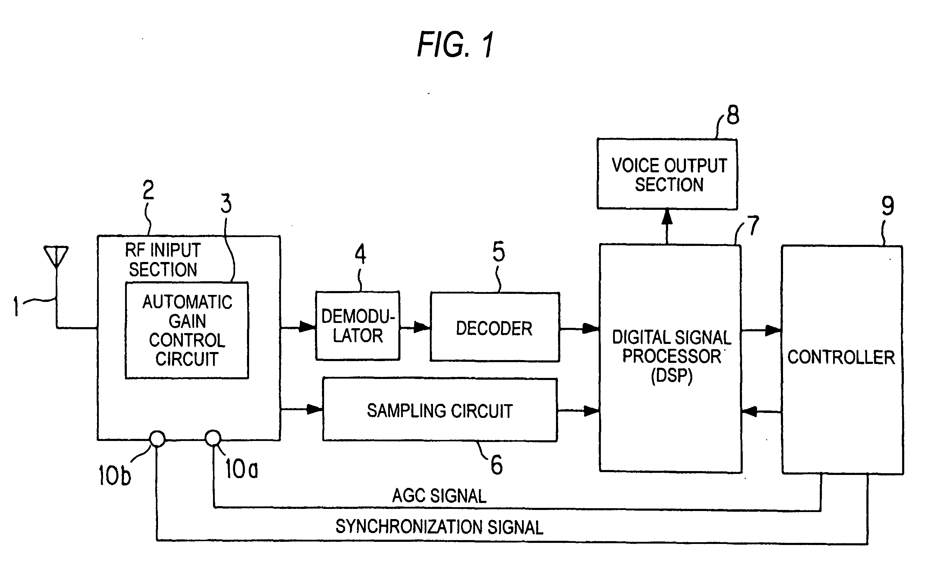

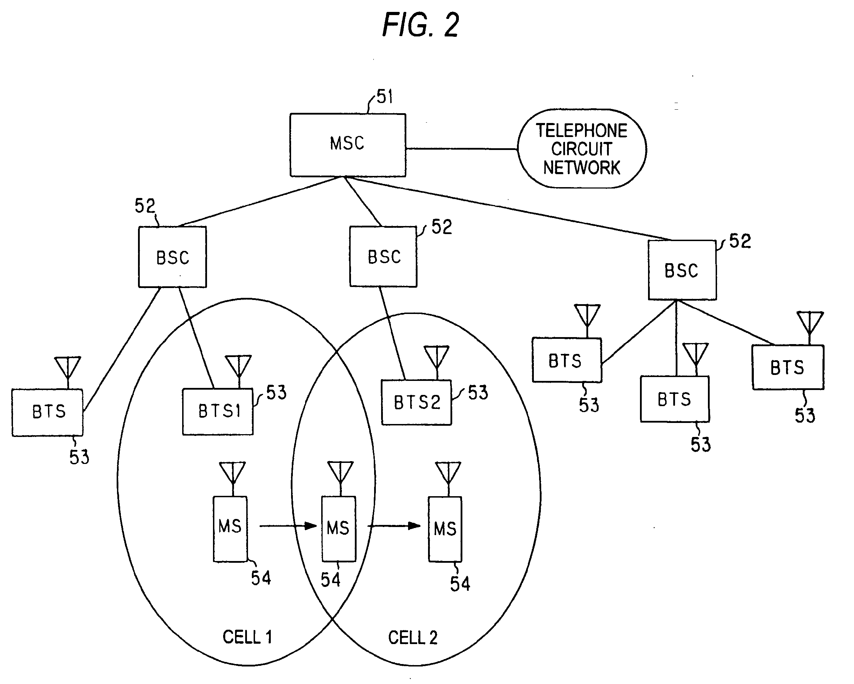

Fig. 1 is a block diagram showing a configuration of a receiver for multi-slot communications equipped with an automatic gain controller according to one embodiment of the invention. Fig. 2 is a block diagram schematically showing a network configuration of a TDMA-based cellular system. This embodiment shows an exemplary configuration of automatic gain controller used in receiving means for performing multi-slot communications.

The receiver for multi-slot communications comprises an antenna 1, a radio frequency (RF) input section 2, a demodulator 4, a decoder 5, a sampling circuit 6, a digital signal processor (DSP) 7, a voice output section 8, and a controller 9. The RF input section 2 comprises an automatic gain control circuit 3 therein and is arranged to amplify a received signal incoming from the antenna 1 while performing gain adjustment. The RF input section 2 has input terminals 10a, 10b for receiving an AGC signal to determine the gain of automatic gain control (AGC) and a synchronization signal to synchronize the received signal to burst signals of a plurality of timings at arbitrary points in time from the controller 9

The demodulator circuit 4 demodulates a received signal amplified in the RF input section 2 and outputs a demodulated signal. The decoder 5 decodes the demodulated signal and outputs decoded received data. The DSP 7, specifically programmed for the receiver circuit, performs signal processing on the decoded receive data and outputs the resulting data. The receive data processed in the DSP 7 is input to the controller 9 and sent to the voice output section 8, and output as a sound signal.

The sampling circuit 6 cyclically samples the signal strength of received signals in a plurality of time slots output from the RF input section 2, and sends to the DSP 7 a received strength signal indicating the received signal strength sampled. These received strength signals undergo signal processing in the DSP 7 and are input as received signal strengths into the controller 7.

The controller 9 determines the communications timing to generate a synchronization signal based on the receive data obtained by processing in the DSP 7 based on the output of the decoder 5, and outputs the synchronization signal to the automatic gain control circuit 3 to control synchronization operation. The controller 9 also generates an AGC signal based on received signal strength obtained through processing of the output of the sampling circuit 6 in the DSP 7, and outputs the AGC signal to the automatic gain control circuit 3 to perform automatic gain control operation. The controller 9 performs operation control on the sections such as the DSP 7.

The receiver for multi-slot communications thus configured is used in the receiver in radio communications apparatus such as a mobile station (MS) and a base transceiver station (BTS) in a cellular system shown in Fig. 2. A cellular system which is based on the TDMA system such as the GSM system comprises at least one mobile services switching center (MSC) 51 which is connected to a telephone circuit network. The mobile services switching center 51 is connected to a plurality of lower base station controllers (BSCs) 52, each of which is connected to at least one lower base transceiver station (BTS) and communications are performed between these nodes. In a cell as a communications area managed by each base transceiver station 53, radio communications are performed between a mobile station (MS) 54 and the base transceiver station 53. While traveling, the MS 54 can communicate with another MS 54 or a telephone circuit network.

Fig. 2 shows roaming of the mobile station 54 from the cell 1 of a base transceiver station 53 (BTS1) to the cell 2 of another base transceiver station 53 (BTS2). The mobile station 54 initially communicates with the base transceiver station 53 (BTS1) via a radio link. The base transceiver station 53 (BTS1) monitors the transmission power of the mobile station 54 during radio communications and reports the result of the monitoring to the mobile services switching center 51 when a handover to another base transceiver station 53 (BTS2) by way of the control by the base station controller 52 is expected. The mobile station 54 receives a list of adjacent base transceiver stations and monitors the signals from the adjacent base transceiver stations in predetermined time intervals based on this list, and reports the monitoring result to the base transceiver station 53 (BTS1).

When the boundary conditions for handover are satisfied, a message is sent to the base station controller 52. This message includes data on the parameters necessary for recognizing the mobile station 54 and a new channel (time slot) to be used for communications between the mobile station 54 and the base transceiver station 53 (BTS2). When preparation is complete, a handover to the base transceiver station 53 (BTS2) takes place under the control of the mobile services switching center 51. This allows the mobile station 54 to communicate with the base transceiver station 53 (BTS2) in the area of the cell 2. In this practice, the mobile station 54 controls itself to track the timing, frequency and signal strength, etc. of the burst signal of the base transceiver station as a communications partner, provides synchronization of the receiver with the transmitter, and maintains the communicating state to perform signal communications.

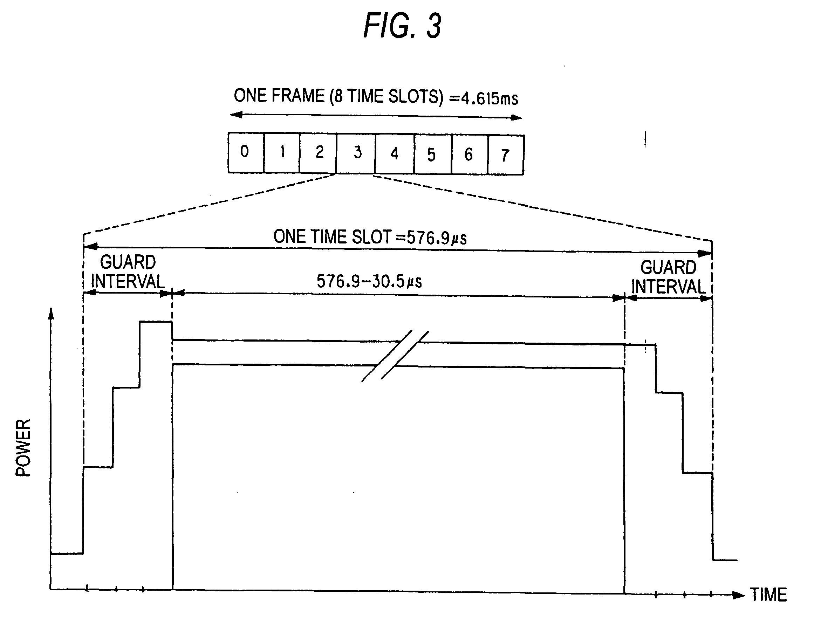

Automatic gain control operation of multi-slot communications according to this embodiment will be described below using as an example the GPRS (General Packet Radio Service) as a packet signal communications system employed in the GSM system. Fig. 3 shows a frame configuration of eight time slots of GSM system as an exemplary TDMA-based frame configuration. In this example, one frame as a unit of communications period comprises eight time slots 0 through 7 and has a length of 4.615 ms. The length of one time slot is 576.9 µs. Each time slot is not completely filled with a burst signal to be transmitted. At the beginning and end of each time slot are provided guard intervals of total 8.25 bits or 30.5 µ s. Thus, even in case the synchronization of the GSM system is not complete, interference between adjacent time slots is suppressed.

In the GPRS in the GSM system, multi-slot communications aiming at faster communications speed take place, where a plurality of time slots are assigned to one mobile station (one user) in a frame, and a plurality of burst signals are received in a plurality of time slots in each mobile station.

A burst signal sent from the base transceiver station 53 is received by the RF input section via the antenna 1 in the mobile station 54 in the cell. Encoded voice data included in the burst signal from the base transceiver station 53 is decoded in the decoder 5, undergoes signal processing in the DSP 7, and output as a sound signal from the voice output section 8.

The controller 9 determines either the timing T1, t2, t3, ..., ti (i=8 in this example) used by the base transceiver station 53 for communications between the base transceiver station 53 and its subordinate mobile station 54 based on receive data obtained from the received signal received by the RF input section 2 via the demodulator circuit 4, the decoder 5 and the DSP 7 and generates a synchronization signal. By sending the synchronization signal to the input terminal 10b of the RF input section b2, the controller 9 establishes synchronization with the base transceiver station 53 by way of a known method of the TDMA system not related to the summary of the invention.

The sampling circuit 6 cyclically samples the signal strength of received signals in a plurality of time slots received by the RF input section 2, and sends to the DSP 7 a received strength signal indicating the received signal strength sampled. The received strength signal is then demodulated. The DSP 7 generates received signal average strengths M1, M2, M3,..., Mi in the time slots in one frame and sends the received signal average strengths to the controller 9. The controller 9 calculates an average value of the received signal average strengths in all time slots (average multi-slot received strength) AVG to obtain a gain value, and generates an AGC signal which is based on the gain value and sends the AGC signal to the input terminal 10b of the RF input section 2.

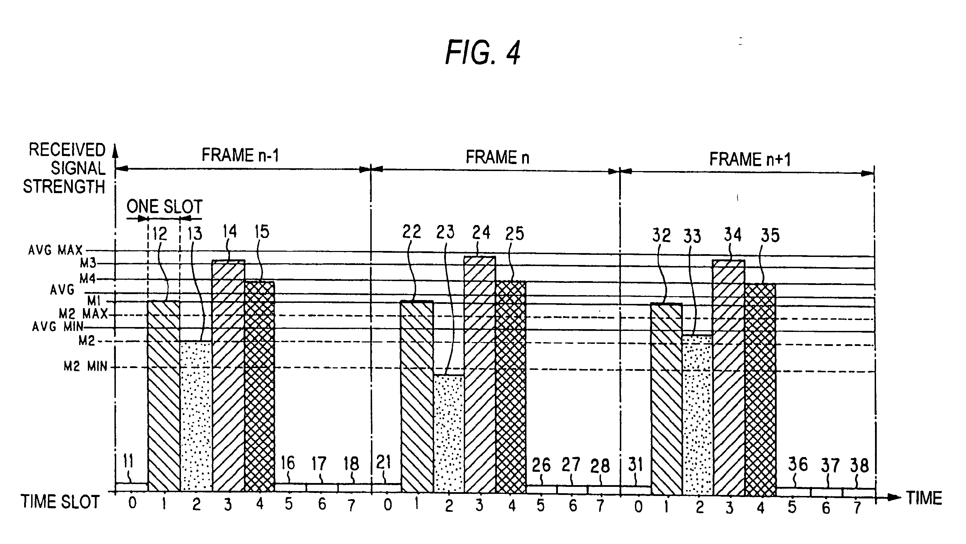

Fig. 4 schematically shows the timing and received signal strength of multi-slot reception of burst signals in four time slots in a frame. In Fig. 4, the horizontal axis represents the time while the vertical axis represents the received signal strength. The example of Fig. 4 shows a received signal for three frames. Each time slot in frame n-1 11, 16-18, frame n 21, 26-28, and frames n+1 31, 36-38 is a time slot which does not receive a burst signal. Each time slot in frame n-1 12-15, frame n 22-25, and frame n+1 32-35 indicates the received signal strengths of four consecutive burst signals in each frame.

To generate an AGC signal used to set the gain of the automatic gain control circuit 3, the received signal average strength M1 in time slot 1 in n-1 frame is obtained from the received signal strength of the burst signal 12 received in time slot 1 and the previous received signal average strength in this time slot. Similarly, the received signal average strength M2 is obtained from the burst signal 13 in time slot 2, the received signal average strength M3 from the burst signal 14 in time slot 3, and the received signal average strength M4 from the burst signal 15 in time slot 4, respectively. The received signal average strength (MRSS) in each of these time slots has a preset tolerance. In Fig. 4, the maximum value and the minimum value of the tolerance range of M2 are represented by M2 MAX and M2 MIN, respectively. Then, an average value (average multi-slot receive strength) AVG of M1, M2, M3 and M4 is obtained. The average multi-slot receive strength AVG also has a preset tolerance. In Fig. 4, the maximum value and the minimum value of the tolerance range of AVG are represented by AVG MAX and AVG MIN, respectively.

In this _embodiment, for example in case burst signals in time slots 22 through 25 in frame n are received and the received signal strengths are measured and a received signal strength Pin in a time slot has exceeded the range from Mi MAX to Mi MIN, the receive signal strength in the time slot is assumed as an abnormal value and a correction value un of Pin is set to 0 or a value approximate to 0. In the example of Fig. 4, in case the received signal strength P2n has lowered the value of M2 MIN, the received signal strength P2n is assumed as an abnormal value and the correction value un of Pin is set to 0 or a value approximate to 0. Then M2 is obtained from the expression (u1P21+u2P22+,...,+unP2n)/n, that is, Σ ujP2j/n (j=1-n).

Next, in case the mean received signal Mi in a time slot has exceeded the range from AVG MAX to AVG MIN, the received signal average strength in the time slot is assumed as an abnormal value and a correction value wi of Mi is set to 0 or a value approximate to 0. In the example of Fig. 4, in case the received signal average strength M2 in time slot 23 has exceeded AVG MAX or lowers AVG MIN, the received signal average strength M2 is assumed as an abnormal value and a correction value w2 of M2 is set to 0 or a value approximate to 0. Then the average multi-slot received strength AVG is obtained from the expression (w1M1+w2M2+,...,+wiMi)/i, that is, ΣwkMk/i (k=1-i).

An AGC signal is generated from the average multi-slot received strength AVG obtained. In the subsequent frame n+1, the gain of the automatic gain control circuit 3 is set in accordance with this AVG value.

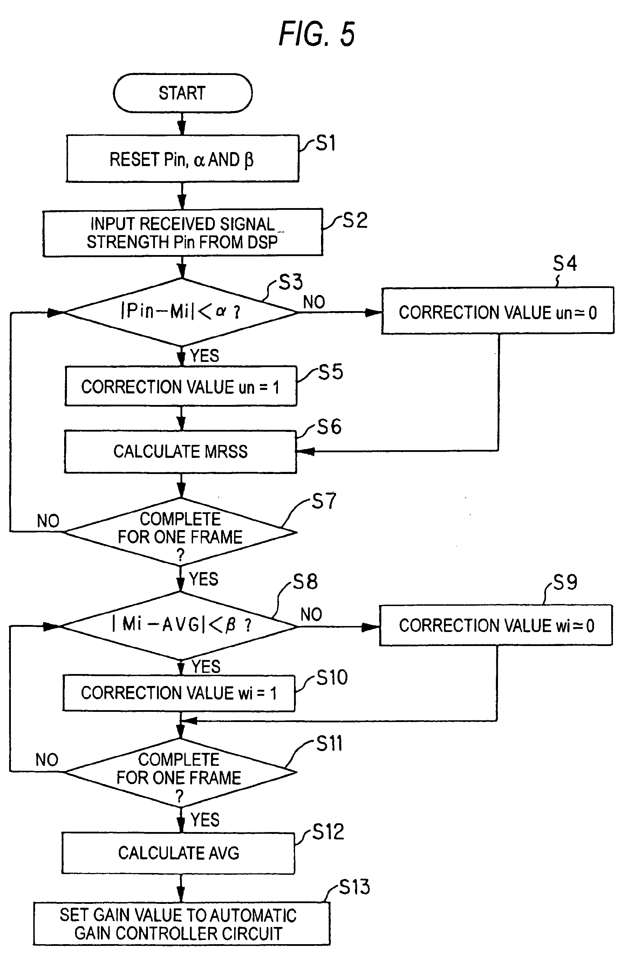

Fig. 5 is a flowchart showing the procedure for obtaining the gain value of an automatic gain control circuit for burst signal reception in multi-slot communications in a receiver for multi-slot communications according to this embodiment. The following procedure describes basically the operation of the controller 9.

The gain value of the automatic gain control circuit is obtained by calculating an average of received signal strengths in a predetermined time period. In step S1, the received signal strength Pin, tolerance α of received signal average strength Mi, and tolerance β of average multi-slot received strength AVG in each slot are reset and initialized. In step S2, the latest received signal strength Pin is input from the DSP.

In step S3, the absolute value of the difference between the received signal strength Pin in each time slot and the received signal average strength Mi is compared with the tolerance α of the preset received signal average strength Mi. In case the value |Pin-Mi| is greater than the tolerance α, the received signal strength Pin in this time slot is assumed as an abnormal value and the correction value un of the received signal strength Pin is set to 0 or a value approximate to 0 in step S4. In case the value |Pin-Mi| is smaller than the tolerance α , the correction value un of the received signal strength Pin is set to 1 in step S5. As a reference value to be compared in determining whether the received signal strength Pin is within the tolerance, it is possible to use the previous received signal average strength in the same time slot or received signal average strength in another time slot, or received signal strength in another time slot in the same frame or a previous frame.

In step S6, the received signal average strength (MRSS) Mi in this time slot is calculated from the expression (u1Pi1+u2Pi2+,...,+unPin)/n, that is, Σ ujPij/n (j=1-n). In step S7, it is determined whether calculation of the received signal average strength Mi is complete for each time slot in a frame. Processing of steps S3 through S6 is repeated until processing is complete for all the time slots in a frame or time slots in a frame which have received burst signals. When processing is complete for one frame, execution proceeds to step S8.

In step S8, the absolute value of the difference between the received signal average strength Mi in a predetermined time slot and the average multi-slot received strength AVG is compared with the tolerance β of the preset multi-slot received signal strength AVG. In case the value |Mi-AVG| is greater than the tolerance β , the received signal average strength Mi in this time slot is assumed as an abnormal value and the correction value wi of the received signal average strength Mi is set to 0 or a value approximate to 0 in step S9. In case the value |Mi-AVG| is smaller than the tolerance β, the correction value wi of the received signal average strength Mi is set to 1 in step S10. As a reference value to be compared in determining whether the received signal average strength Mi is within the tolerance, it is possible to use the previous multi-slot received strength or received signal average strength in another time slot in the same frame or a previous frame.

In step S11, it is determined whether setting of the correction value wi of received signal average strength Mi is complete for each slot in a frame. Processing of steps S8 through S10 is repeated until processing is complete for all the time slots in a frame or time slots in a frame which have received burst signals. When processing is complete for one frame, execution proceeds to step S12. In step S12, the average multi-slot received strength AVG in this frame is calculated from the expression (w1M1+w2M2+,...,+wiMi)/i, that is, ΣwkMk/i (k=1-i).

Based on the average multi-slot received strength AVG thus obtained, an AGC signal is generated in step S13 and output to the automatic gain control circuit 3 and a gain value is set. The gain value can be represented by Σ wkMk/i (k=1-i) as the average multi-slot received strength AVG. This value can be set to 1 in case each correction value u1 through un and w1 through wi is not abnormal, and to a value smaller than 1 in case the correction value assumed as abnormal. This provides an average value obtained by assigning a weight to each of a plurality of received signal strengths.

In this embodiment, as mentioned hereabove, a weight is assigned to each received signal strength in each of a plurality of time slots in multi-slot communications by way of GPRS, etc. in a cellular system which is based on a TDMA system such as a GSM system. In case the received signal strength is assumed as an abnormal value, the correction value of weight is set to 0 or a value approximate to 0 thus calculating an average value and setting a gain value based on the average value obtained to perform automatic gain control. This makes it possible to receive burst signals in a plurality of time slots in a frame by way of a same gain setting with reduced effect of fading, etc. in a stable fashion. It is possible to receive burst signals in a plurality of time slots in a frame with single gain setting in a stable fashion.

While the invention has been described in detail and in terms of its specific embodiments, those skilled in the art will recognize that various changes and modifications can be made in it without departing from the spirit and scope thereof. This application is based on the Japanese Patent Application filed July 27, 2001 (Japanese Patent Application No. 2001-227739), the disclosure of which is incorporated herein by reference.

### <Industrial Applicability>

As described hereabove, the invention has an advantage of receiving signals in a plurality of time slots in a frame by way of a same gain setting in a stable fashion with reduced effect of fading, etc. in a cellular system which is based on the TDMA system performing multi-slot communications.

## Claims

1. An automatic gain controller which controls the signal strength to a predetermined level in time-division-based multi-slot communications which perform communications in a plurality of time slots in a predetermined frame time, said automatic gain controller comprising:
received signal strength detecting means for detecting a received signal strength in each of said plurality of time slots;
received signal average strength calculating means for determining whether said detected received signal strength is abnormal, assigning a weight to the received signal strength which is lighter than that assigned to a normal value in case the signal strength value is abnormal, and then calculating a received signal average strength in each time slot;
average multi-slot received strength calculating means for determining whether said calculated received signal average strength is abnormal, assigning a weight to the received signal strength which is lighter than that assigned to a normal value and in case the signal strength is abnormal, and then calculating an average value of a plurality of received signal average strengths in a frame; and
gain control means for controlling the received signal strength to a predetermined level by using a gain control signal which is based on said calculated average multi-slot received strength.

2. The automatic gain controller according to claim 1,
wherein said received signal average strength calculating means comprises comparing means for making a comparison to determine whether said detected received signal strength exceeds a predetermined tolerance and weight setting means for assuming an abnormal value in case said tolerance is exceeded in the result of said comparison and setting a correction value used as a coefficient of said weight to 0 or a value approximate to 0.

3. The automatic gain controller according to claim 1,
wherein said average multi-slot received strength calculating means comprises:
comparing means for making a comparison to determine whether said calculated received signal average strength exceeds a predetermined tolerance; and:
weight setting means for assuming an abnormal value in case said tolerance is exceeded in the result of said comparison and setting a correction value used as a coefficient of said weight to 0 or a value approximate to 0.

4. An automatic gain control method for controlling the signal strength to a predetermined level in time-division-based multi-slot communications which perform communications in a plurality of time slots in a predetermined frame time, said automatic gain control method comprising:
a received signal strength detecting step of detecting a received signal strength in each of said plurality of time slots;
a received signal average strength calculating step of determining whether said detected received signal strength is abnormal and in case the signal strength value is abnormal, assigning a weight to the received signal strength which is lighter than that assigned to a normal value thus calculating a received signal average strength in each time slot;
an average multi-slot received strength calculating step of determining whether said calculated received signal average strength is abnormal, assigning a weight to the received signal strength which is lighter than that assigned to a normal value in case the signal strength is abnormal, and calculating an average value of a plurality of received signal average strengths in a frame, and
a gain control step of controlling the received signal strength to a predetermined level by using a gain control signal which is based on said calculated average multi-slot received strength.

5. Radio communications apparatus used for time-division-based multi-slot communications which perform communications in a plurality of time slots in a predetermined frame time, said radio communications apparatus comprising:
receiving means for receiving a burst signal in each time slot in synchronization with a plurality of time slots in said frame time;
received signal strength detecting means for detecting a received signal strength in each of said plurality of time slots;
received signal average strength calculating means for determining whether said detected received signal strength is abnormal, assigning a weight to the received signal strength which is lighter than that assigned to a normal value in case the signal strength value is abnormal, and then calculating a received signal average strength in each time slot; and
gain control means for controlling the received signal strength to a predetermined level by using a gain control signal which is based on said calculated average multi-slot received strength.

6. A program having a program code for implementing the automatic gain control method according to claim 4.
